# EUROPEAN PATENT SPECIFICATION

(11) **EP 4 403 936 B1**
(45) Date of publication and mention of the grant of the patent: **22.04.2026**
(21) Application number: 22887003.6
(22) Date of filing: 25.10.2022
(51) Int. Cl.: G01R 31/12, G01R 31/14, H02H 1/00

(54) **DISCHARGE DETECTION DEVICE**
ENTLADUNGSDETEKTIONSVORRICHTUNG
DISPOSITIF DE DÉTECTION DE DÉCHARGE

(30) Priority: 27.10.2021 JP 2021175250
(43) Date of publication of application: 24.07.2024
(73) Proprietor: Nitto Kogyo Corporation, Nagakute-shi, Aichi 480-1189 (JP)
(72) Inventor: MIYAMOTO Atsushi, Nagakute-shi, Aichi 480-1189 (JP); SAKAI Tomoyasu, Nagakute-shi, Aichi 480-1189 (JP); AJIOKA Hiyori, Nagakute-shi, Aichi 480-1189 (JP)
(74) Representative: Müller Schupfner & Partner Patent- und Rechtsanwaltspartnerschaft mbB (Muc)
(86) International application number: PCT/JP2022/039704
(87) International publication number: WO 2023/074677

(56) References cited:
- JP-A- 2007 240 160
- JP-A- 2007 240 160
- JP-A- 2010 276 365
- JP-A- 2011 085 393
- JP-A- 2015 175 689
- JP-A- H07 143 667
- US-A- 6 137 418
- US-A1- 2003 098 694
- US-A1- 2019 173 271

## Description

### Technical Field

The present invention relates to a discharge detector.

### Background Art

Japanese Patent Application Kokai Publication No. 2019-184480 (Patent Document 1) discloses a discharge detection structure to detect discharge occurred in electrical circuits. This discharge detection structure is built in, for example, a branch breaker configuring a distribution board to be electrically connected to an electrical circuit, such as indoor wirings. The electrical circuit is electrically connected to a load, not shown. The load refers to a device that operates by consuming power, such as a lighting fixture, a display, an air conditioner, and a refrigerator, for example. The discharge detection structure is provided with a low pass filter section, a high pass filter section, a determination section, and a cutoff section. The low pass filter section is electrically connected to the secondary side of make-and-break switches configuring the branch breaker. The high pass filter section is electrically connected to the secondary side of the low pass filter section. The determination section is electrically connected to a detection section configuring the high pass filter section. The cutoff section is electrically connected to the determination section. If an accident, such as tracking, a short circuit, disconnection, and a leakage current, occurs in the electrical circuit or the load, discharge takes place between electric wires or between electrodes. If discharge occurs, a noise is superimposed on the voltage or current in the electrical circuit. The high pass filter section detects noises in a high frequency band superimposed on the voltage or current. The determination section determines whether discharge has occurred based on the noise detected by the high pass filter section. If determining that discharge has occurred, the cutoff section sends a signal to the make-and-break switches of the branch breakers and changes the make-and-break switches from a closed state to an open state to interrupt the branch breakers. Meanwhile, the low pass filter section prevents propagation of a noise of discharge occurred in an electrical circuit electrically connected to one branch breaker to the discharge detection structure built in another branch breaker.

US Patent US6137418 (Patent Document 2) discloses an arc fault or partial discharge detector with a voltage sensing network connected between the three phases of a power line; and a current transformer sensor connected between the phases. The sensed signals are amplified, filtered, and conditioned/peak held.

### Prior Art Documents

### Patent Document

Patent Document 1: Japanese Patent Application Kokai Publication No. 2019-184480
Patent Document 2: US Patent No. US6137418.

### Disclosure of the Invention

### Problems to be solved by the Invention

The conventional discharge detection structure disclosed in Japanese Patent Application Kokai Publication No. 2019-184480 is built in one branch breaker and detects a noise of discharge occurred in an electrical circuit electrically connected to the secondary side of the one branch breaker. The low pass filter section prevents propagation of the noise to each other within the discharge detection structures respectively built in a plurality of branch breakers. Thus, a determination result "discharge has occurred" of the determination section means that discharge has occurred in one electrical circuit electrically connected to the secondary side of a specific branch breaker.

In such a discharge detection structure in the past, however, it is a premise that the power transmission system of the power source supplied to the distribution board is a single phase alternating current. If the power transmission system of the power source is a three-phase alternating current, the determination section is not capable of specifying one electrical circuit where discharge has occurred. That is, if the power transmission system of the power source is a single phase alternating current, a discharge noise superimposed on the power source appears before and after the peak value in one waveform of the alternating current. However, if the power transmission system of the power source is a three-phase alternating current, for example if it is a three-phase three-wire system, a noise of discharge occurred in one electrical circuit electrically connected to any one phase-connection between the R phase - the S phase, between the S phase - the T phase, or between the T phase - the R phase propagates to other electrical circuits electrically connected to the respective other two phase-connections. The low pass filter section is not capable of preventing propagation of the noise from the one phase-connection to the other two phase-connections. The discharge noise thus appears before and after the peak value of the alternating waveform of each of the connections between the R phase - the S phase, between the S phase - the T phase, and between the T phase - the R phase. The determination section is thus not capable of specifying which connection between the R phase - the S phase, between the S phase - the T phase, or between the T phase - the R phase is the source of the discharge.

In this situation, it is considered to provide each of the connections between the R phase - the S phase, between the S phase - the T phase, and between the T phase - the R phase with the discharge detection structure in the past. The three discharge detection structures allow determination whether discharge has occurred in each of the three waveforms of the three-phase alternating current. Moreover, if each of the three discharge detection structures determines that "discharge has occurred", it is possible to specify which connection between the R phase - the S phase, between the S phase - the T phase, or between the T phase - the R phase is the source of the discharge by comparing the discharge noise detected by each of the three discharge detection structures. However, such a device is not practical due to the too many components because the device requires the three discharge detection structures and at least one arithmetic section to compare discharge noises detected by the discharge detection structures.

The present invention has been made in view of the above problems, and it is an object thereof to provide a discharge detector allowing one determination section to determine whether discharge has occurred in electrical circuits of a three-phase alternating current and to specify a source of the discharge.

### Means to solve the Problems

(1) To achieve the above object, a discharge detector of the present invention for detecting occurrence of discharge based on a noise in a high frequency band superimposed on an alternating current power source supplied from a power circuit of a three-phase alternating current, the discharge detector includes: at least one filter section electrically connected between two phases out of a first phase, a second phase, and a third phase of the power circuit and configured to extract a predetermined frequency component from the alternating current power source, an amplification section configured to amplify an output of the filter section, a smoothing section configured to smooth an output of the amplification section, a phase angle setting section configured to set a starting point of noise measurement for each connection between the first phase - the second phase, between the second phase - the third phase, and between the third phase - the first phase, a phase division section configured to define a plurality of domains by dividing one cycle of a voltage waveform or a current waveform of each connection between the first phase - the second phase, between the second phase - the third phase, and between the third phase - the first phase based on the starting point of noise measurement, and a determination section configured to detect a noise at a predetermined frequency included in an output of the smoothing section, configured to specify at least one domain coincident with a timing of detecting the noise out of the plurality of domains defined by the phase division section, and configured to specify which connection between the first phase - the second phase, between the second phase - the third phase, or between the third phase - the first phase is a source of the noise.
(2) It is preferred that, in the discharge detector of (1) above, the phase angle setting section determines a first starting point of noise measurement based on the voltage waveform or the current waveform of any one phase-connection between the first phase - the second phase, between the second phase - the third phase, or between the third phase - the first phase, and determines second and third starting points of noise measurement for the other two phase-connections based on the first starting point of noise measurement and a shift in a phase angle of the voltage waveform or the current waveform of each connection between the first phase - the second phase, between the second phase - the third phase, and between the third phase - the first phase.
(3) It is preferred that, in the of (1) above, the phase angle setting section determines the starting point of noise measurement for each connection between the first phase - the second phase, between the second phase - the third phase, and between the third phase - the first phase based on the voltage waveform or the current waveform of each of these three phase-connections.
(4) It is preferred that, in the of (1) above, the phase division section defines a peak time domain including time before and after a peak value and a zero cross time domain including time before and after a 0 value for the one cycle of the voltage waveform or the current waveform of each connection between the first phase - the second phase, between the second phase - the third phase, and between the third phase - the first phase, and the determination section calculates a value of a difference between a first output of the smoothing section in the peak time domain and a second output of the smoothing section in the zero cross time domain, and if the difference value is a first threshold or more, determines that discharge has occurred and specifies which connection between the first phase - the second phase, between the second phase - the third phase, or between the third phase - the first phase is a source of the discharge.
(5) It is preferred that, in the of (1) above, the phase division section defines a peak time domain including time before and after a peak value for the one cycle of the voltage waveform or the current waveform of each connection between the first phase - the second phase, between the second phase - the third phase, and between the third phase - the first phase, and the determination section specifies, if the timing of detecting the noise is coincident with the peak time domain, which connection between the first phase - the second phase, between the second phase - the third phase, or between the third phase - the first phase is the source of the noise.
(6) It is preferred that, in the of (4) above, the determination section determines whether the second output of the smoothing section in the zero cross time domain is a second threshold or more, the second threshold being a value smaller than the first threshold, and if the second output is the second threshold or more, reports that it is not possible to determine whether discharge has occurred.
(7) It is preferred that, in the of (4) above, the determination section determines whether the second output of the smoothing section in the zero cross time domain is a second threshold or more, the second threshold being a value smaller than the first threshold, and if the second output is the second threshold or more, reduces an amplification factor of the amplification section.

### Effects of the Invention

The discharge detector of the present invention has the one determination section capable of determining whether discharge has occurred in an electrical circuit of the three-phase alternating current and capable of specifying the source of the discharge.

### Brief Description of the Drawings

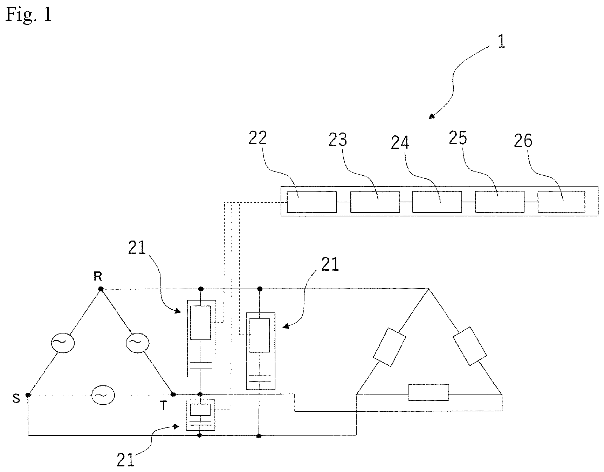

Fig. 1 is a schematic diagram illustrating a three-phase three-wire electrical circuit provided with a discharge detector according to a first embodiment of the present invention.

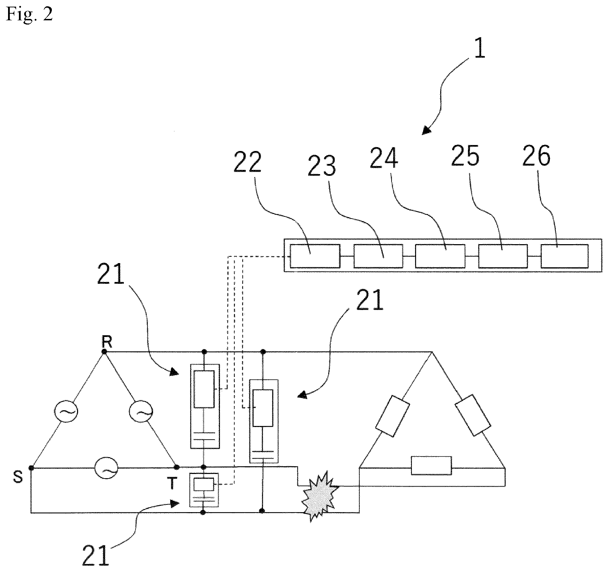

Fig. 2 is a schematic diagram illustrating that discharge has occurred in an electrical circuit electrically connected between the S phase - the T phase in Fig. 1.

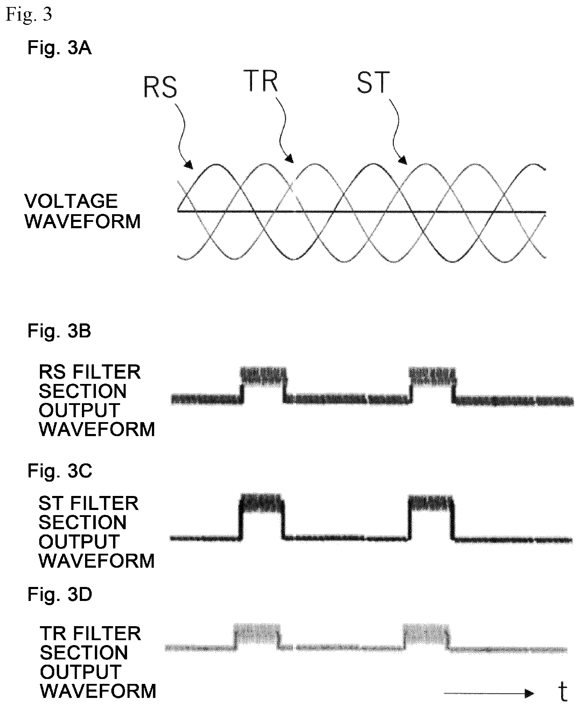

Fig. 3A illustrates respective voltage waveforms between the R phase - the S phase, between the S phase - the T phase, and between the T phase - the R phase. Fig. 3B illustrates an output waveform of a filter section electrically connected between the R phase - the S phase. Fig. 3C illustrates an output waveform of a filter section electrically connected between the S phase - the T phase. Fig. 3D illustrates an output waveform of a filter section electrically connected between the T phase - the R phase.

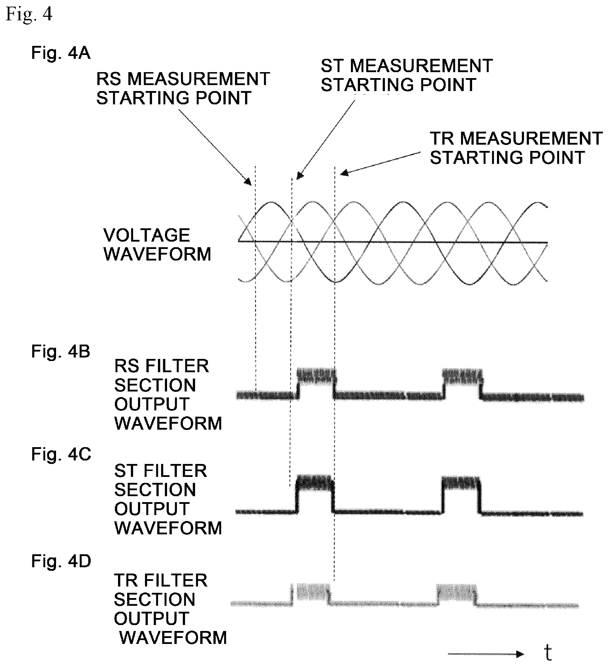

Fig. 4A illustrates respective voltage waveforms between the R phase - the S phase, between the S phase - the T phase, and between the T phase - the R phase. Fig. 4B illustrates an output waveform of the filter section electrically connected between the R phase - the S phase. Fig. 4C illustrates an output waveform of the filter section electrically connected between the S phase - the T phase. Fig. 4D illustrates an output waveform of the filter section electrically connected between the T phase - the R phase. Three broken lines in Figs. 4A through 4D indicate respective starting points of noise measurement between the R phase - the S phase, between the S phase - the T phase, and between the T phase - the R phase.

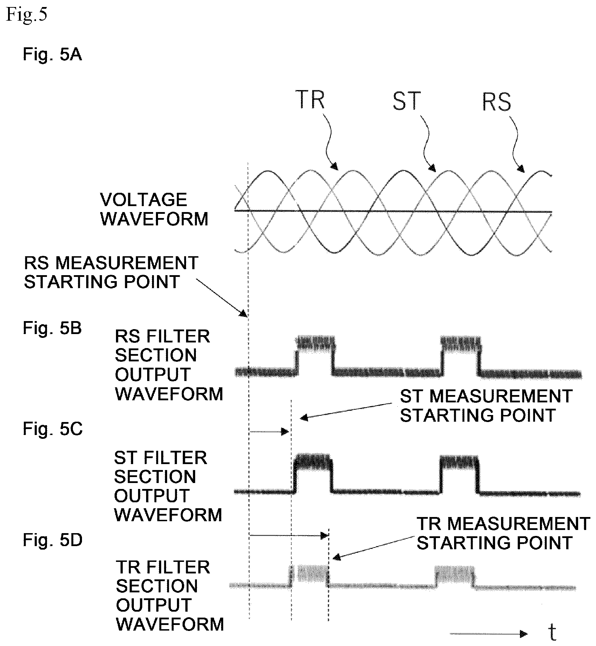

Fig. 5A illustrates respective voltage waveforms between the R phase - the S phase, between the S phase - the T phase, and between the T phase - the R phase. Fig. 5B illustrates an output waveform of the filter section electrically connected between the R phase - the S phase. Fig. 5C illustrates an output waveform of the filter section electrically connected between the S phase - the T phase. Fig. 5D illustrates an output waveform of the filter section electrically connected between the T phase - the R phase. Three broken lines in Figs. 5A through 5D indicate respective starting points of noise measurement between the R phase - the S phase, between the S phase - the T phase, and between the T phase - the R phase.

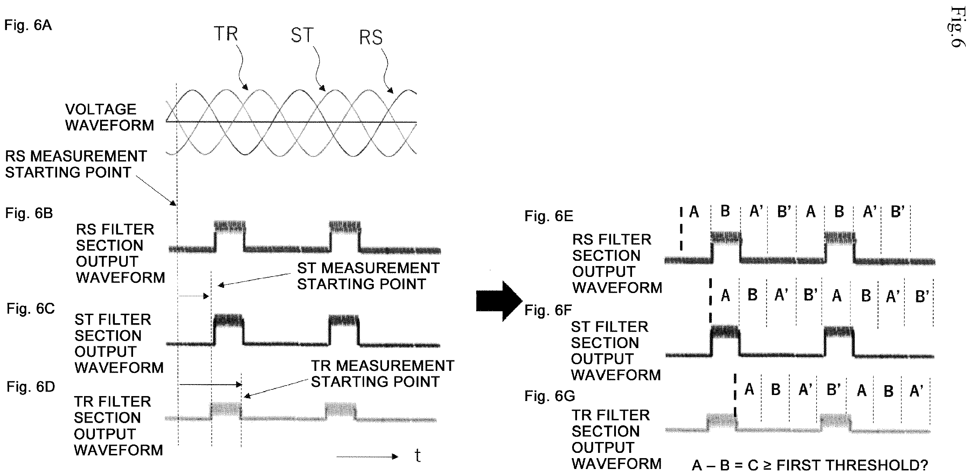

Fig. 6A illustrates respective voltage waveforms between the R phase - the S phase, between the S phase - the T phase, and between the T phase - the R phase. Fig. 6B illustrates an output waveform of the filter section electrically connected between the R phase - the S phase. Fig. 6C illustrates an output waveform of the filter section electrically connected between the S phase - the T phase. Fig. 6D illustrates an output waveform of the filter section electrically connected between the T phase - the R phase. Three broken lines in Figs. 6A through 6D indicate respective starting points of noise measurement between the R phase - the S phase, between the S phase - the T phase, and between the T phase - the R phase. Fig. 6E illustrates the relationship between the output waveform in Fig. 6B and peak time domains A, A' and zero cross time domains B, B' of the voltage waveform between the R phase - the S phase. Fig. 6F illustrates the relationship between the output waveform in Fig. 6C and peak time domains A, A' and zero cross time domains B, B' of the voltage waveform between the S phase - the T phase. Fig. 6G illustrates the relationship between the output waveform in Fig. 6D and peak time domains A, A' and zero cross time domains B, B' of the voltage waveform between the T phase - the R phase.

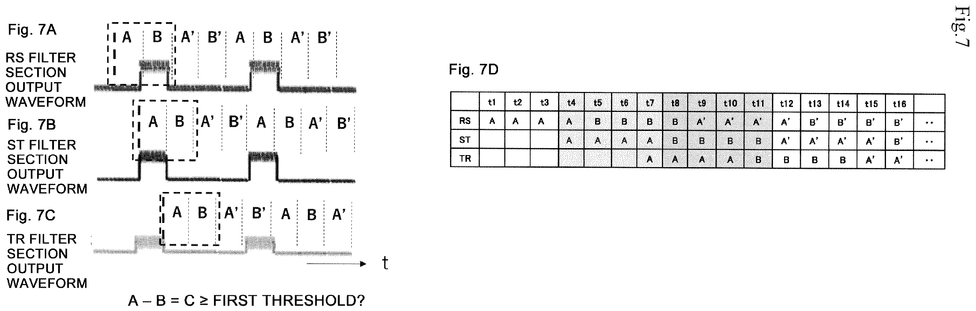

Fig. 7A illustrates the relationship between the output waveform of the filter section electrically connected between the R phase - the S phase and the peak time domains A, A' and the zero cross time domains B, B' of the voltage waveform between the R phase - the S phase. Fig. 7B illustrates the relationship between the output waveform of the filter section electrically connected between the S phase - the T phase and the peak time domains A, A' and the zero cross time domains B, B' of the voltage waveform between the S phase - the T phase. Fig. 7C illustrates the relationship between the output waveform of the filter section electrically connected between the T phase - the R phase and the peak time domains A, A' and the zero cross time domains B, B' of the voltage waveform between the T phase - the R phase. Fig. 7D is a table illustrating the relationship between time t and the peak time domains A, A' and the zero cross time domains B, B' in each of Figs. 7A, 7B, and 7C.

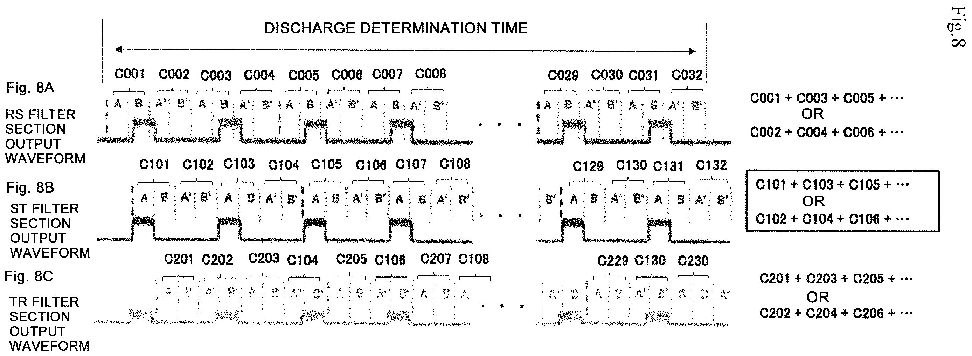

Fig. 8A illustrates the relationship between the output waveform of the filter section electrically connected between the R phase - the S phase and the peak time domains A, A' and the zero cross time domains B, B' of the voltage waveform between the R phase - the S phase, and the output waveform includes continuously detected discharge noises. Fig. 8B illustrates the relationship between the output waveform of the filter section electrically connected between the S phase - the T phase and the peak time domains A, A' and the zero cross time domains B, B' of the voltage waveform between the S phase - the T phase, and the output waveform includes continuously detected discharge noises. Fig. 8C illustrates the relationship between the output waveform of the filter section electrically connected between the T phase - the R phase and the peak time domains A, A' and the zero cross time domains B, B' of the voltage waveform between the T phase - the R phase, and the output waveform includes continuously detected discharge noises.

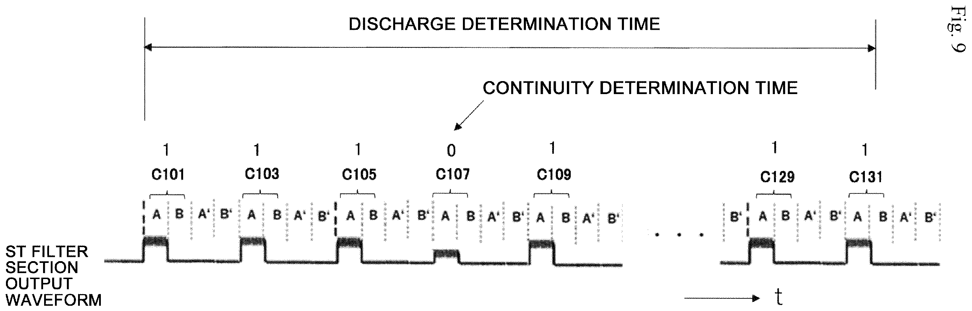

Fig. 9 illustrates the relationship between the output waveform of the filter section electrically connected between the S phase - the T phase and the peak time domains A, A' and the zero cross time domains B, B' of the voltage waveform between the S phase - the T phase, and the output waveform includes continuously detected discharge noises.

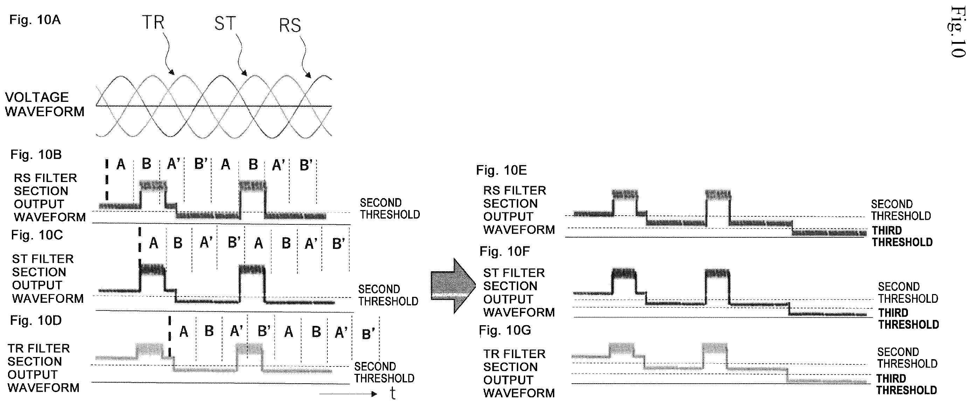

Fig. 10A illustrates the respective voltage waveforms between the R phase - the S phase, between the S phase - the T phase, and between the T phase - the R phase. Fig. 10B illustrates the relationship between a second threshold, the output waveform of the filter section electrically connected between the R phase - the S phase, and the peak time domains A, A' and the zero cross time domains B, B' of the voltage waveform between the R phase - the S phase. Fig. 10C illustrates the relationship between the second threshold, the output waveform of the filter section electrically connected between the S phase - the T phase, and the peak time domains A, A' and the zero cross time domains B, B' of the voltage waveform between the S phase - the T phase. Fig. 10D illustrates the relationship between the second threshold, the output waveform of the filter section electrically connected between the T phase - the R phase, and the peak time domains A, A' and the zero cross time domains B, B' of the voltage waveform between the T phase - the R phase. Fig. 10E illustrates the relationship between the output waveform in Fig. 10B, the second threshold, and a third threshold. Fig. 10F illustrates the relationship between the output waveform in Fig. 10C, the second threshold, and the third threshold. Fig. 10G illustrates the relationship between the output waveform in Fig. 10D, the second threshold, and the third threshold.

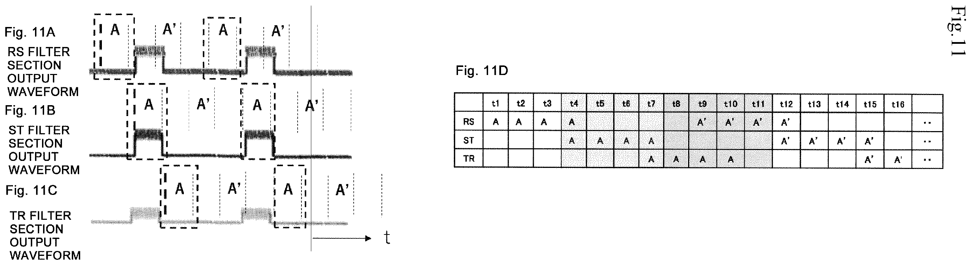

Fig. 11A illustrates the relationship between the output waveform of the filter section electrically connected between the R phase - the S phase and the peak time domains A, A' of the voltage waveform between the R phase - the S phase. Fig. 11B illustrates the relationship between the output waveform of the filter section electrically connected between the S phase - the T phase and the peak time domains A, A' of the voltage waveform between the S phase - the T phase. Fig. 11C illustrates the relationship between the output waveform of the filter section electrically connected between the T phase - the R phase and the peak time domains A, A' of the voltage waveform between the T phase - the R phase. Fig. 11D is a table illustrating the relationship between the time t and the peak time domains A, A' in each of Figs. 11A, 11B, and 11C.

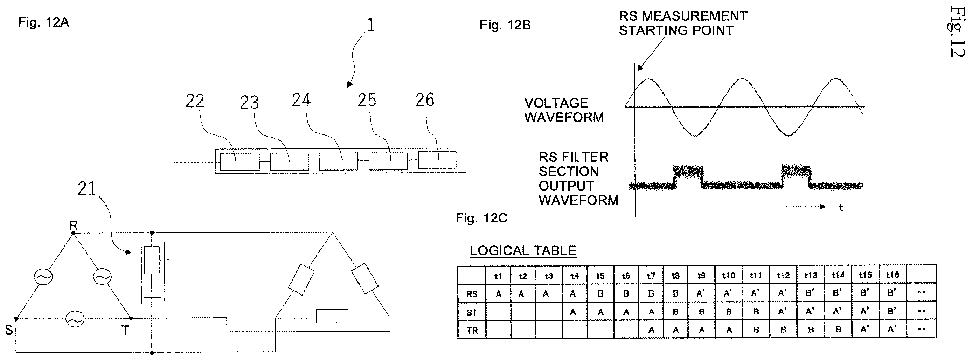

Fig. 12A is a schematic diagram illustrating a three-phase three-wire electrical circuit provided with a discharge detector according to a second embodiment of the present invention. Fig. 12B illustrates the voltage waveform between the R phase - the S phase and the output waveform of the filter section electrically connected between the R phase - the S phase. Fig. 12C is a logical table defining the relationship between time t, peak time domains A, A', and zero cross time domains B, B' of the voltage waveform of each of the connections between the R phase - the S phase, between the S phase - the T phase, and the T phase - the R phase.

### Modes for Carrying Out the Invention

### 1. Discharge Detector according to First Embodiment

Fig. 1 illustrates a three-phase three-wire electrical circuit electrically connected to a discharge detector 1 according to the first embodiment of the present invention. The electrical circuit illustrated in Fig. 1 is configured with a delta connected power circuit delta connected three loads, and the discharge detector 1 in the present embodiment. The power circuit is provided with an R phase voltage line, an S phase voltage line, and a T phase voltage line. To the respective voltage lines of the R phase, the S phase, and the T phase, a 200 V alternating current power source with a phase angle each shifted 120°, for example, is supplied. The alternating current power source is supplied to the delta connected three loads via three electric wires. Each of the three loads is electrically connected to any one connection between the R phase - the S phase, between the S phase - the T phase, or between the T phase - the R phase. The discharge detector 1 in the present embodiment is configured with three filter sections 21, an amplification section 22, a phase angle setting section 23, a phase division section 24, a smoothing section 25, and a determination section 26.

### 1.1 Filter Section

Each of the three filter sections 21 illustrated in Fig. 1 is electrically connected to any one connection between the R phase - the S phase, between the S phase - the T phase, or between the T phase - the R phase. The filter section 21 is, for example, an RC circuit and has a configuration where a capacitor and a resistor are connected in series. For example, if discharge occurs in an indoor wiring or a load, a high frequency noise is superimposed on the alternating current power source. The filter section 21 passes, without attenuation, frequency components higher than a cutoff frequency. The noises in a high frequency band are thus detected that are superimposed on the voltage or current of the alternating current power source.

In this situation, noise propagation in the case that discharge occurs in a three-phase three-wire electrical circuit is described with reference to Fig. 2 and Figs. 3A through 3D. As illustrated in Fig. 2, it is assumed that discharge has occurred in, for example, the electrical circuit electrically connected between the S phase - the T phase. The noise occurred by the discharge is superimposed on the voltage waveform between the S phase - the T phase illustrated in Fig. 3A and appear before and after the peak value of the voltage waveform. The noise is detected by the filter section 21 electrically connected to the voltage waveform between the S phase - the T phase. Fig. 3C illustrates the output waveform of the filter section 21 electrically connected to the voltage waveform between the S phase - the T phase. The output waveform in Fig. 3C is equivalent to two cycles of the voltage waveform and includes two noises.

In the three-phase three-wire electrical circuit, a noise of discharge occurred in one electrical circuit electrically connected to any one phase-connection between the R phase - the S phase, between the S phase - the T phase, or between the T phase - the R phase propagates to other electrical circuits electrically connected respectively to the other two phase-connections. The noise of discharge between the S phase - the T phase illustrated in Fig. 3C thus propagates to the other electrical circuits electrically connected respectively between the R phase - the S phase and between the T phase - the R phase and is superimposed on the respective voltage waveforms between the R phase - the S phase and between the T phase - the R phase. The noise superimposed on the voltage waveform between the R phase - the S phase is detected by the filter section 21 electrically connected between the R phase - the S phase. The noise superimposed on the voltage waveform between the T phase - the R phase is detected by the filter section 21 electrically connected between the T phase - the R phase. Fig. 3B illustrates the output waveform of the filter section 21 electrically connected to the voltage waveform between the R phase - the S phase. Fig. 3D illustrates the output waveform of the filter section 21 electrically connected to the voltage waveform between the T phase - the R phase. The output waveforms both in Figs. 3B and 3D also include two noises corresponding to the output waveform in Fig. 3C.

The discharge detector 1 in the present embodiment is capable of specifying, if each of the three filter sections 21 detects a noise by propagation of the noise occurred by discharge, which connection between the R phase - the S phase, between the S phase - the T phase, or between the T phase - the R phase is the source of the discharge. The source of the discharge is mainly specified by the phase angle setting section 23, the phase division section 24, and the determination section 26. The phase angle setting section 23, the phase division section 24, and the determination section 26 are detailed later.

### 1.2 Amplification Section

The amplification section 22 illustrated in Fig. 1 is electrically connected to the output side of the respective three filter sections 21. The amplification section 22 amplifies, for example, the respective outputs of the three filter sections 21 20 times. In this situation, the noise amplified by the amplification section 22 generates a waveform alternately repeating "0" and "1" at short intervals. It is difficult to determine whether discharge has occurred based on such a short intermittent waveform. Upon this, the noise amplified by the amplification section 22 is smoothed by the smoothing section 25. The smoothing section 25 is detailed later.

### 1.3 Phase Angle Setting Section

The phase angle setting section 23 illustrated in Fig. 1 sets a starting point of noise measurement for each connection between the R phase - the S phase, between the S phase - the T phase, and between the T phase - the R phase. The starting point of noise measurement may be determined based on, for example, the respective voltage waveforms between the R phase - the S phase, between the S phase - the T phase, and between the T phase - the R phase illustrated in Fig. 3A. The respective starting points of noise measurement between the R phase - the S phase, between the S phase - the T phase, and between the T phase - the R phase are preferably time points of 45° in the voltage waveforms illustrated by the three broken lines in Fig. 4A. The time points of 45° in the voltage waveforms are the starting points of the peak time domains A, A' described later. It should be noted that the starting point of noise measurement may be the starting points of the zero cross time domains B, B' described later.

In this situation, the respective starting points of noise measurement between the R phase - the S phase, between the S phase - the T phase, and between the T phase - the R phase may be determined based on any one voltage waveform. For example, the starting point of noise measurement between the R phase - the S phase is determined based on the voltage waveform between the R phase - the S phase. Then, the respective starting points of noise measurement between the S phase - the T phase and between the T phase - the R phase are determined based on the starting point of noise measurement between the R phase - the S phase. Specifically, in the case of the delta connection illustrated in Fig. 1, the phase angles of the respective voltage waveforms between the R phase - the S phase, between the S phase - the T phase, and between the T phase - the R phase are shifted 120° each. A cycle of each voltage waveform is 16.7 ms. If each voltage waveform is 60 Hz, the starting point of noise measurement connection between the S phase - the T phase is a time point 16.7 ms×1/3 delayed from the starting point of noise measurement between the R phase - the S phase. The starting point of noise measurement between the T phase - the R phase is a time point 16.7 ms×2/3 delayed from the starting point of noise measurement between the R phase - the S phase.

It should be noted that the present embodiment has a configuration where all the power circuit and the three loads illustrated in Fig. 1 are delta connected while the connection is not limited to this configuration. The three-phase alternating current electrical circuit electrically connected to the discharge detector 1 in the present embodiment may have a configuration where one or both the power circuit and the three loads are Y (star) connected. Even if the power circuit is Y connected, the starting points of noise measurement of the respective voltage waveforms may be determined based on the shifts in the phase angles of the respective voltage waveforms between the R phase - the S phase, between the S phase - the T phase, and between the T phase - the R phase.

### 1.4 Phase Division Section

The phase division section 24 illustrated in Fig. 1 defines the peak time domains including the time before and after the peak value and the zero cross time domains including the time before and after the 0 value based on the respective starting points of noise measurement and values in one cycle of the respective voltage waveforms between the R phase - the S phase, between the S phase - the T phase, and between the T phase - the R phase. The phase division section 24 allows specifying the peak time domains A, A' and the zero cross time domains B, B' over a plurality of cycles by, for example, outputting a pulse in predetermined timings (refer to Figs. 6E through 6G). The determination section 26 described later specifies the peak time domains A, A' and the zero cross time domains B, B' over a plurality of cycles based on the pulse output from the phase division section 24.

### 1.5 Smoothing Section

The smoothing section 25 illustrated in Fig. 1 smooths the output amplified by the amplification section 22. The smoothing is a process of, for example, connecting the peaks in the waveform of the amplified noise. As described above, the noise amplified by the amplification section 22 generates a waveform alternately repeating "0" and "1" at short intervals. The smoothed noise waveform generates a line connecting the peaks of "1" in the amplified noise waveform. It should be noted that the smoothing section 25 may smooth the noise waveform by holding the maximum value (peak hold) of the noise amplified by the amplification section 22. The smoothing of the noise waveform by the smoothing section 25 prevents instantaneous variation in the signal level from affecting the determination result of the determination section 26.

It should be noted that the noise waveforms respectively illustrated in Figs. 3B through 3D, Figs. 4B through 4D, Figs. 5B through 5D, Figs. 6B through 6G, Figs. 7A through 7C, Figs. 8A through 8C, Fig. 9, Figs. 10B through 10G, Figs. 11A through 11C, and Fig. 12B are output waveforms of the three filter sections 21 and are not noise waveforms smoothed by the smoothing section 25.

### 1.6 Determination Section

Examples of the determination section 26 illustrated in Fig. 1 to be used include arithmetic devices, such as a microcontroller unit (MCU), a microcomputer, and a processor. The determination section 26 is electrically connected to the respective output side of the phase angle setting section 23, the phase division section 24, and the smoothing section 25. The respective output of the phase angle setting section 23, the phase division section 24, and the smoothing section 25 is input to the determination section 26.

Firstly, the determination section 26 obtains the starting points of noise measurement of the respective voltage waveforms between the R phase - the S phase, between the S phase - the T phase, and between the T phase - the R phase from the phase angle setting section 23 (refer to the three broken lines in Figs. 6A through 6D). Secondly, the determination section 26 obtains pulses to specify the peak time domains A, A' and the zero cross time domains B, B' over a plurality of cycles of the respective voltage waveforms between the R phase - the S phase, between the S phase - the T phase, and between the T phase - the R phase from the phase division section 24 (refer to Figs. 6E through 6G). Thirdly, the determination section 26 obtains the noise waveform smoothed by the smoothing section 25. Then, the determination section 26 executes a process of determining whether discharge has occurred and a process of specifying the source of the discharge based on the respective noise waveforms between the R phase - the S phase, between the S phase - the T phase, and between the T phase - the R phase.

As illustrated in Figs. 6E through 6G, the determination section 26 specifies the peak time domains A, A' and the zero cross time domains B, B' over a plurality of cycles of the respective voltage waveforms between the R phase - the S phase, between the S phase - the T phase, and between the T phase - the R phase based on the starting points of noise measurement set by the phase angle setting section 23 and the pulses input from the phase division section 24.

Then, the determination section 26 calculates a value of a difference C between a first output of the smoothing section 25 in the peak time domain A and a second output of the smoothing section 25 in the zero cross time domain B. Then, the determination section 26 determines whether discharge has occurred based on the value of the difference C between the first output and the second output. Subsequently, the determination section 26 specifies the peak time domains A', A and the zero cross time domains B', B over the plurality of cycles of the voltage waveforms and repeatedly calculates the value of the difference C between the first output and the second output to determine whether discharge has occurred. The determination section 26 determines that "discharge has occurred" if the value of the difference C between the first output and the second output is the first threshold or more set in advance.

For example, as illustrated in Figs. 7A through 7C, it is assumed that the respective noise waveforms are measured between the R phase - the S phase, between the S phase - the T phase, and between the T phase - the R phase.

At first, the determination section 26 calculates the value of the difference C between the first output of the smoothing section 25 in the peak time domain A and the second output of the smoothing section 25 in the zero cross time domain B for the waveform of the noise measured between the R phase - the S phase. In this case, the difference C is a negative value that is less than the first threshold and thus the determination section 26 does not determine that "discharge has occurred".

Then, the determination section 26 calculates the value of the difference C between the first output of the smoothing section 25 in the peak time domain A and the second output of the smoothing section 25 in the zero cross time domain B for the waveform of the noise measured between the S phase - the T phase. In this case, the difference C is a positive value that is the first threshold or more and thus the determination section 26 determines that "discharge has occurred".

Then, the determination section 26 calculates the value of the difference C between the first output of the smoothing section 25 in the peak time domain A and the second output of the smoothing section 25 in the zero cross time domain B for the waveform of the noise measured between the T phase - the R phase. In this case, the difference C is 0, which is less than the first threshold, and thus the determination section 26 does not determine that "discharge has occurred".

After that, the determination section 26 specifies that the source of the discharge is "between the S phase - the T phase" based on the respective determination results between the R phase - the S phase, between the S phase - the T phase, and between the T phase - the R phase.

Fig. 7D is a table illustrating the relationship between time t and the peak time domains A, A' and the zero cross time domains B, B' in each of Figs. 7A, 7B, and 7C. The respective determinations between the R phase - the S phase, between the S phase - the T phase, and between the T phase - the R phase by the determination section 26 described above are executed during the times t1 through t14. For the determination between the R phase - the S phase, the noise waveform data obtained during the times t1 through t8 is used. For the determination between the S phase - the T phase, the noise waveform data obtained during the times t4 through t11 is used. For the determination between the T phase - the R phase, the noise waveform data obtained during the times t7 through t14 is used.

In the case of calculating the value of the difference C between the first output of the smoothing section 25 in the peak time domain A and the second output of the smoothing section 25 in the zero cross time domain B, each value of the first output and the second output is an additional value or an average value. Specifically, in Fig. 7D, the value of the first output of the smoothing section 25 in the peak time domain A between the R phase - the S phase is an additional value or an average value of the outputs of the smoothing section 25 during the times t1 through t4. The value of the second output of the smoothing section 25 in the zero cross time domain B between the R phase - the S phase is an additional value or an average value of the outputs of the smoothing section 25 during the times t5 through t8. The value of the first output of the smoothing section 25 in the peak time domain A between the S phase - the T phase is an additional value or an average value of the outputs of the smoothing section 25 during the times t4 through t7. The value of the second output of the smoothing section 25 in the zero cross time domain B between the S phase - the T phase is an additional value or an average value of the outputs of the smoothing section 25 during the times t8 through t11. The value of the first output of the smoothing section 25 in the peak time domain A between the T phase - the R phase is an additional value or an average value of the outputs of the smoothing section 25 during the times t7 through t10. The value of the second output of the smoothing section 25 in the zero cross time domain B between the T phase - the R phase is an additional value or an average value of the outputs of the smoothing section 25 during the times t11 through t14.

It should be noted that, in the case of calculating the value of the difference C between the first output of the smoothing section 25 in the peak time domain A and the second output of the smoothing section 25 in the zero cross time domain B, one value of the first output and one value of the second output may be used. For example, in Fig. 7D, the value of the first output of the smoothing section 25 in the peak time domain A between the R phase - the S phase is any one value out of the outputs of the smoothing section 25 during the times t1 through t4 (e.g., time t4). The value of the second output of the smoothing section 25 in the zero cross time domain B between the R phase - the S phase is any one value out of the outputs of the smoothing section 25 during the times t5 through t8 (e.g., time t5). The value of the first output of the smoothing section 25 in the peak time domain A between the S phase - the T phase is any one value out of the outputs of the smoothing section 25 during the times t4 through t7 (e.g., time t7). The value of the second output of the smoothing section 25 in the zero cross time domain B between the S phase - the T phase is any one value out of the outputs of the smoothing section 25 during the times t8 through t11 (e.g., time t8). The value of the first output of the smoothing section 25 in the peak time domain A between the T phase - the R phase is any one value out of the outputs of the smoothing section 25 during the times t7 through t10 (e.g., time t10). The value of the second output of the smoothing section 25 in the zero cross time domain B between the T phase - the R phase is any one value out of the outputs of the smoothing section 25 during the times t11 through t14 (e.g., time t11).

The discharge detector 1 in the present embodiment is capable of determining whether discharge has occurred for each connection between the R phase - the S phase, between the S phase - the T phase, and between the T phase - the R phase by the amplification section 22, the phase angle setting section 23, the phase division section 24, the smoothing section 25, and the determination section 26, each provided one. It is thus possible to hold the number of components of the discharge detector 1 down to an extremely small number.

### 1.7 Discharge Determination Time

In the exemplification of Figs. 7A through 7D, the determination section 26 determines that "discharge has occurred" if the value of the difference C is the first threshold or more. However, each load configuring the three-phase three-wire electrical circuit illustrated in Fig. 1 sometimes generates a sudden noise at the first threshold or more. Not to cause the determination section 26 to erroneously determine the sudden noise of the load as discharge, it is preferred to include the continuity of the noise at the first threshold or more in the criteria for determining whether discharge has occurred.

Figs. 8A through 8C illustrate output waveforms of the respective filter sections 21 electrically connected between the R phase - the S phase, between the S phase - the T phase, and between the T phase - the R phase. The output waveform illustrated in each of Figs. 8A through 8C includes continuously detected discharge noises. In Figs. 8A through 8C, it is assumed that the source of the discharge is the circuit electrically connected between the S phase - the T phase and the discharge noise propagates to the respective circuits electrically connected between the R phase - the S phase and between the T phase - the R phase.

The determination section 26 obtains the noise waveform smoothed by the smoothing section 25 for each connection between the R phase - the S phase, between the S phase - the T phase, and between the T phase - the R phase. The determination section 26 then specifies the peak time domains A, A' and the zero cross time domains B, B' over a plurality of cycles of the respective voltage waveform between the R phase - the S phase, between the S phase - the T phase, and between the T phase - the R phase based on the starting points of noise measurement set by the phase angle setting section 23 and the pulses input from the phase division section 24. The determination section 26 calculates the value of the difference C between the first output of the smoothing section 25 in the peak time domains A, A' and the second output of the smoothing section 25 in the zero cross time domains B, B' for each connection between the R phase - the S phase, between the S phase - the T phase, and between the T phase - the R phase.

As a result of this arithmetic process, no values of the difference C of the first threshold or more are calculated between the R phase - the S phase illustrated in Fig. 8A and between the T phase - the R phase illustrated in Fig. 8C. The value of the difference C of the first threshold or more is calculated between the S phase - the T phase illustrated in Fig. 8B.

Specifically, the determination section 26 calculates the value of the difference C between the first output of the smoothing section 25 in the peak time domain A and the second output of the smoothing section 25 in the zero cross time domain B at C101 in Fig. 8B. In this case, the difference C is a positive value that is the first threshold or more. In this situation, the determination section 26 the number of calculating the value of the difference C of the first threshold or more between the S phase - the T phase while discharge determination time set in advance passes.

The discharge determination time is, for example, 500 ms. The respective voltage waveforms between the R phase - the S phase, between the S phase - the T phase, and between the T phase - the R phase are 60 Hz, and one cycle of each voltage waveform is 16.7 ms. The determination section 26 calculates the value of the difference C between the first output of the smoothing section 25 in the peak time domain A and the second output of the smoothing section 25 in the zero cross time domain B once per cycle of the voltage waveform. The determination section 26 adds "1" if the value of the difference C of the first threshold or more is calculated. Then, the determination section 26 determines that "discharge has occurred" if the additional value when 500 ms has passed is, for example, "15" or more. As a result, the determination section 26 does not erroneously determine a sudden noise of the load as discharge.

The determination section 26 in the present embodiment calculates the difference C based on the outputs in the domains A, B corresponding to a positive half cycle of the voltage waveform at C101, C103, C105, C107, ... in Fig. 8C and adds "1" if the value of the difference C of the first threshold or more is calculated while the process is not limited to this configuration. The determination section 26 may calculate the difference C based on the outputs in the domains A', B' corresponding to a negative half cycle of the voltage waveform at C102, C104, C106, C108, ... in Fig. 8C and may add "1" if the value of the difference C is the first threshold or more.

The determination section 26 in the present embodiment also adds "1" if the value of the difference C of the first threshold or more is continuously calculated within the discharge determination time of 500 ms. The determination section 26 resets the additional value to "0" if the value of the difference C of less than the first threshold is calculated at any one of C103, C105, C107, ... in Fig. 8B.

### 1.8 Continuity Determination Time

In the exemplification illustrated in Figs. 8A through 8C, the determination section 26 determines that "discharge has occurred" if a noise at the first threshold or more continues 15 or more times within the discharge determination time of 500 ms. However, the discharge noise sometimes instantaneously attenuates. For example, if the noise instantaneously attenuates to less than the first threshold at C107 in Fig. 8B, the continuity of the noise at the first threshold or more is broken and thus the determination section 26 resets the number of calculating the difference C of the first threshold or more to "0". In other words, the determination section 26 erroneously determines that discharge has not occurred.

In order to prevent such an erroneous determination due to the instantaneous attenuation of noise, the determination section 26 preferably determines the length of time while the noise has attenuated to less than the first threshold. Then, if the time while the noise has attenuated to less than the first threshold is within the continuity determination time set in advance, the determination section 26 does not reset the number of calculating the value of the difference C of the first threshold or more to "0". The continuity determination time is, for example, the length (8.35 ms) of the half cycle of the voltage waveform.

Fig. 9 illustrates the output waveform of the filter section 21 electrically connected between the S phase - the T phase. The output waveform illustrated in Fig. 9 includes continuously detected discharge noises. At C101, C103, and C105 in Fig. 9, noises at the first threshold or more are detected continuously three times. Then, at C107, a noise less than the first threshold is detected. After that, at C109, ..., C129, and C131, noises at the first threshold or more are detected continuously 12 times.

At C107 in Fig. 9, the determination section 26 calculates the value of the difference C between the first output of the smoothing section 25 in the peak time domain A and the second output of the smoothing section 25 in the zero cross time domain B. In this case, the difference C is a positive value of less than the first threshold. In this situation, the determination section 26 does not reset the number "3" of calculating the value of the difference C of the first threshold or more at C101, C103, and C105.

Then, at C109 in Fig. 9, the determination section 26 calculates the value of the difference C between the first output of the smoothing section 25 in the peak time domain A and the second output of the smoothing section 25 in the zero cross time domain B. In this case, the difference C is a positive value of the first threshold or more. In this situation, the determination section 26 determines the time while the value of the difference C at C107 in Fig. 9 has reduced to less than the first threshold, in other words, the time while the noise has attenuated to less than the threshold is within the continuity determination time. As a result of the determination, the determination section 26 firstly continues the measurement of the discharge determination time of 500 ms. Secondly, the determination section 26 adds the number "0" of calculating the value of the difference C of less than the first threshold at C107 in Fig. 9 to "3". Thirdly, the determination section 26 adds the number "1" of calculating the value of the difference C of the first threshold or more at C109 in Fig. 9 to "3".

After that, the determination section 26 calculates the value of the difference C of the first threshold or more continuously 11 times. As a result, the number of calculating the value of the difference C of the first threshold or more within the discharge determination time of 500 ms becomes "15" and the determination section 26 determines that "discharge has occurred".

If the value of the difference C at C109 in Fig. 9 is less than the first threshold, the determination section 26 firstly terminates the measurement of the discharge determination time. Secondly, the determination section 26 resets the number "3" of calculating the value of the difference C of the first threshold or more. After that, if the value of the difference C of the first threshold or more is calculated, the determination section 26 starts measurement of the discharge determination time and repeats the process described above.

### 1.9 Measures for Noise generated by Load

In the three-phase three-wire electrical circuit illustrated in Fig. 1, the load electrically connected to any one connection between the R phase - the S phase, between the S phase - the T phase, or between the T phase - the R phase sometimes generates a noise. Fig. 10C illustrates the output waveform of the filter section 21 if discharge occurs in the electrical circuit electrically connected between the S phase - the T phase and the load configuring the electrical circuit generates a noise. In the output waveform between the S phase - the T phase illustrated in Fig. 10C, the noise of the discharge appears in the peak time domain A immediately after the starting point of noise measurement and the noise of the load appears in the respective zero cross time domains B before and after the peak time domain A. The load noise also appears in the output waveform between the R phase - the S phase illustrated in Fig. 10B and in the output waveform between the T phase - the R phase illustrated in Fig. 10D.

In the output waveform between the S phase - the T phase illustrated in Fig. 10C, there is a possibility that the value of the difference C between the first output of the smoothing section 25 in the peak time domain A and the second output of the smoothing section 25 in the zero cross time domain B is less than the first threshold. As a result, the determination section 26 erroneously determines that discharge has not occurred even though discharge has occurred.

In order to prevent such an erroneous determination of the determination section 26 due to the load noise, the second threshold is set that is a value smaller than the first threshold. The determination section 26 determines whether the second output of the smoothing section 25 in the zero cross time domains B, B' is the second threshold or more. If the second output is the second threshold or more, the determination section 26 reports that it is not possible to determine whether discharge has occurred. For example, the determination section 26 reports that it is not possible to determine whether discharge has occurred using sound output from a speaker, light from an LED, display on a display, and the like.

In addition, in the output waveform between the R phase - the S phase illustrated in Fig. 10B and the output waveform between the T phase - the R phase illustrated in Fig. 10D, the determination section 26 preferably determines whether the second output of the smoothing section 25 in the zero cross time domains B, B' is the second threshold or more. If the second output is the second threshold or more, the determination section 26 reports that it is not possible to determine whether discharge has occurred.

Each output waveform illustrated in Figs. 10E through 10G includes a load noise of more than the second threshold. The load noise continues over the period from before to after the first discharge noise in the output waveform. If the load noise of more than the second threshold continues, the amplification factor of the amplification section 22 illustrated in Fig. 1 is reduced. This allows a decrease in the second output of the smoothing section 25 in the zero cross time domains B, B' to the second threshold or less. As a result, the determination section 26 is allowed to determine whether discharge has occurred without being affected by the load noise.

In this situation, if the load generating the noise is turned OFF, the load noise in the output waveform illustrated in Figs. 10E through 10G disappears. In this case, the amplification factor of the amplification section 22 illustrated in Fig. 1 is preferably returned to a standard set value. The amplification factor of the amplification section 22 determines the discharge detection limit of the discharge detector 1. A higher amplification factor of the amplification section 22 allows the discharge detector 1 to detect smaller discharge. Thus, after the load noise disappears, the reduced amplification factor of the amplification section 22 is preferably increased to the standard set value.

To return the amplification factor of the amplification section 22 to the standard set value, a third threshold is set that is a value smaller than the second threshold. As illustrated in Figs. 10E through 10G, the determination section 26 determines whether the second output of the smoothing section 25 in the zero cross time domains B, B' is the third threshold or more. If the second output is less than the third threshold, the determination section 26 increases the amplification factor of the amplification section 22 to the standard set value. It should be noted that, if the load noise of more than the second threshold continues, the amplification factor of the amplification section 22 is reduced to a value causing the second output of the smoothing section 25 in the zero cross time domains B, B' to be the third threshold or more.

### 1.10 Determination based only on Peak Time Domain

Figs. 11A through 11C illustrates the output waveforms of the respective filter sections 21 electrically connected between the R phase - the S phase, between the S phase - the T phase, and between the T phase - the R phase. The determination section 26 is also capable of determining whether discharge has occurred based only on the first output of the smoothing section 25 in the peak time domain A in Figs. 11A through 11C. In other words, neither the first output of the smoothing section 25 in the peak time domain A' nor the second output of the smoothing section 25 in the zero cross time domains B, B' are used for determination whether discharge has occurred.

The discharge noise appears before and after the peak value of the voltage waveform of any one connection between the R phase - the S phase, between the S phase - the T phase, or between the T phase - the R phase electrically connected to the electrical circuit as the source of discharge. In the output waveforms illustrated in Figs. 11A through 11C, the determination section 26 determines whether the first output of the smoothing section 25 in the peak time domain A is the first threshold or more. Only the output waveform between the S phase - the T phase illustrated in Fig. 11B has the first output of the smoothing section 25 in the peak time domain A of the first threshold or more. Accordingly, the determination section 26 determines that "discharge has occurred" in a timing of the times t4 through t7 illustrated in Fig. 11D and specifies that the source of the discharge is "between the S phase - the T phase".

It should be noted that some devices provided with a motor, such as an electric drill and an electric mixer, continuously generate a noise at the level more than the first threshold during normal operation. The noise generated by normal operation of a load is superimposed on the entire peak time domains A, A' and zero cross time domains B, B' of the voltage waveforms of the alternating current power source. As a result, the first output of the smoothing section 25 in the peak time domain A in each of the connections between the R phase - the S phase, between the S phase - the T phase, and between the T phase - the R phase is sometimes the first threshold or more. In such a case, the determination section 26 reports that it is not possible to determine whether discharge has occurred. Alternatively, the determination section 26 reduces the amplification factor of the amplification section 22 illustrated in Fig. 1 to cause the load noise to be less than the first threshold.

### 2. Discharge Detector according to Second Embodiment

Although the discharge detector 1 in the first embodiment described above is provided with the three filter sections 21 illustrated in Fig. 1, the discharge detector may be provided with at least one filter section 21. Fig. 12A illustrates a three-phase three-wire electrical circuit electrically connected to a discharge detector 1 according to the second embodiment of the present invention. The discharge detector 1 in the second embodiment is provided with, for example, one filter section 21 electrically connected between the R phase - the S phase. All the amplification section 22, the phase angle setting section 23, the phase division section 24, the smoothing section 25, and the determination section 26 illustrated in Fig. 12Ahave the same configuration as those in the first embodiment. Note that the process of the determination section 26 in the second embodiment is different from that in the first embodiment.

### 2.1 Setting Starting Point of Noise Measurement

The phase angle setting section 23 sets a starting point of noise measurement for each connection between the R phase - the S phase, between the S phase - the T phase, and between the T phase - the R phase. At first, the phase angle setting section 23 determines the starting point of noise measurement between the R phase - the S phase based on the voltage waveform between the R phase - the S phase. The starting point of noise measurement between the R phase - the S phase is the time point of the time t1 in Fig. 12C.

Then, the phase angle setting section 23 determines the starting point of noise measurement between the S phase - the T phase based on the starting point of noise measurement between the R phase - the S phase. The starting point of noise measurement between the S phase - the T phase is the time point 16.7 ms×1/3 delayed from the starting point of noise measurement between the R phase - the S phase and is the time point of the time t4 in Fig. 12C.

Then, the phase angle setting section 23 determines the starting point of noise measurement between the T phase - the R phase based on the starting point of noise measurement between the R phase - the S phase. The starting point of noise measurement between the T phase - the R phase is the time point 16.7 ms×2/3 delayed from the starting point of noise measurement between the R phase - the S phase and the time point of the time t7 in Fig. 12C.

### 2.2 Specification of Peak Time Domain and Zero Cross Time Domain

The phase division section 24 defines a peak time domain including time before and after the peak value and a zero cross time domain including time before and after the 0 value based on the respective starting points of noise measurement and the respective values in one cycle of the voltage waveforms between the R phase - the S phase, between the S phase - the T phase, and between the T phase - the R phase. The phase division section 24 allows specifying the peak time domains A, A' and the zero cross time domains B, B' over a plurality of cycles by, for example, outputting a pulse in predetermined timings. As illustrated in Fig. 12C, the phase division section 24 divides the one cycle of the voltage waveform into 16 domains A, B, A', B'.

### 2.3 Specification of Source of Discharge

Fig. 12C illustrates a logical table defining the correspondence between the respective peak time domains A, A' and the respective zero cross time domains B, B' between the R phase - the S phase, between the S phase - the T phase, and between the T phase - the R phase. The determination section 26 refers to the logical table illustrated in Fig. 12C if the filter section 21 illustrated in Fig. 12A detects a noise. Then, the determination section 26 specifies the respective domains A, B, A', B' between the R phase - the S phase, between the S phase - the T phase, and between the T phase - the R phase in the timing of noise detection.

For example, Fig. 12B illustrates the output waveform of the filter section 21 illustrated in Fig. 12A. This output waveform includes two noises. The first noise is detected in the timing during the times t7 through t10 in Fig. 12C. This noise appears in the zero cross time domains B, B and the peak time domains A', A' in the voltage waveform between the R phase - the S phase. The determination section 26 specifies the domains A, B, A', B' during the times t7 through t10 in Fig. 12C for each connection between the S phase - the T phase and between the T phase - the R phase. At first, the voltage waveform between the S phase - the T phase during the times t7 through t10 is the peak time domain A and the zero cross time domains B, B, B. Then, the voltage waveform between the T phase - the R phase during the times t7 through t10 is all the peak time domains A, A, A, A. As described above, the noise generated by the discharge appears before and after the peak value of the voltage waveform. Accordingly, the determination section 26 determines that "discharge has occurred between the T phase - the R phase".

### 3. Others

The discharge detector of the present invention is not limited to the configurations in the first and second embodiments described above. For example, the three filter sections 21 illustrated in Fig. 1 or the one filter section 21 illustrated in Fig. 12A may be stored in one housing together with the amplification section 22, the phase angle setting section 23, the phase division section 24, the smoothing section 25, and the determination section 26. The discharge detector thus configures a cohesive unit. In addition, the discharge detector in the first and second embodiments described above has a configuration of detecting discharge based on the noise superimposed on the voltage while the discharge detector is not limited to this configuration. The discharge detector of the present invention may have a configuration of detecting discharge based on the noise superimposed on the current.

### Description of Reference Numerals

- 1: Discharge Detector
- 21: Filter Section
- 22: Amplification Section
- 23: Phase Angle Setting Section
- 24: Phase Division Section
- 25: Smoothing Section
- 26: Determination Section

## Claims

1. A discharge detector (1) for detecting occurrence of discharge based on a noise in a high frequency band superimposed on an alternating current power source supplied from a power circuit of a three-phase alternating current, the discharge detector comprising:
at least one filter section (21) electrically connected between two phases out of a first phase, a second phase, and a third phase of the power circuit and configured to extract a predetermined frequency component from the alternating current power source,
an amplification section (22) configured to amplify an output of the filter section,
a smoothing section (25) configured to smooth an output of the amplification section,
a phase angle setting section (23) configured to set a starting point of noise measurement for each connection between the first phase - the second phase, between the second phase - the third phase, and between the third phase - the first phase,
a phase division section (24) configured to define a plurality of domains by dividing one cycle of a voltage waveform or a current waveform of each connection between the first phase - the second phase, between the second phase - the third phase, and between the third phase - the first phase based on the starting point of noise measurement, and
a determination section (26) configured to detect a noise at a predetermined frequency included in an output of the smoothing section, configured to specify at least one domain coincident with a timing of detecting the noise out of the plurality of domains defined by the phase division section, and configured to specify which connection between the first phase - the second phase, between the second phase - the third phase, or between the third phase - the first phase is a source of the noise.

2. The discharge detector according to claim 1, wherein the phase angle setting section determines a first starting point of noise measurement based on the voltage waveform or the current waveform of any one phase-connection between the first phase - the second phase, between the second phase - the third phase, or between the third phase - the first phase, and determines second and third starting points of noise measurement for the other two phase-connections based on the first starting point of noise measurement and a shift in a phase angle of the voltage waveform or the current waveform of each connection between the first phase - the second phase, between the second phase - the third phase, and between the third phase - the first phase.

3. The discharge detector according to claim 1, wherein the phase angle setting section determines the starting point of noise measurement for each connection between the first phase - the second phase, between the second phase - the third phase, and between the third phase - the first phase based on the voltage waveform or the current waveform of each of these three phase-connections.

4. The discharge detector according to claim 1, wherein the phase division section defines a peak time domain including time before and after a peak value and a zero cross time domain including time before and after a 0 value for the one cycle of the voltage waveform or the current waveform of each connection between the first phase - the second phase, between the second phase - the third phase, and between the third phase - the first phase, and
the determination section calculates a value of a difference between a first output of the smoothing section in the peak time domain and a second output of the smoothing section in the zero cross time domain, and if the difference value is a first threshold or more, determines that discharge has occurred and specifies which connection between the first phase - the second phase, between the second phase - the third phase, or between the third phase - the first phase is a source of the discharge.

5. The discharge detector according to claim 1, wherein the phase division section defines a peak time domain including time before and after a peak value for the one cycle of the voltage waveform or the current waveform of each connection between the first phase - the second phase, between the second phase - the third phase, and between the third phase - the first phase, and
the determination section specifies, if the timing of detecting the noise is coincident with the peak time domain, which connection between the first phase - the second phase, between the second phase - the third phase, or between the third phase - the first phase is the source of the noise.

6. The discharge detector according to claim 4, wherein the determination section determines whether the second output of the smoothing section in the zero cross time domain is a second threshold or more, the second threshold being a value smaller than the first threshold, and if the second output is the second threshold or more, reports that it is not possible to determine whether discharge has occurred.

7. The discharge detector according to claim 4, wherein the determination section determines whether the second output of the smoothing section in the zero cross time domain is a second threshold or more, the second threshold being a value smaller than the first threshold, and if the second output is the second threshold or more, reduces an amplification factor of the amplification section.

## Patentansprüche

1. Ein Entladungsdetektor (1) zum Erfassen des Auftretens einer Entladung auf der Grundlage eines Rauschens in einem Hochfrequenzband, das einer Wechselstromquelle überlagert ist, die von einem Stromkreis eines dreiphasigen Wechselstroms gespeist wird, wobei der Entladungsdetektor umfasst:
mindestens einen Filterabschnitt (21), der elektrisch zwischen zwei Phasen aus einer ersten Phase, einer zweiten Phase und einer dritten Phase des Stromkreises geschaltet ist und so konfiguriert ist, dass er eine vorbestimmte Frequenzkomponente aus der Wechselstromquelle extrahiert,
einen Verstärkerabschnitt (22), der so konfiguriert ist, dass er ein Ausgangssignal des Filterabschnitts verstärkt,
einen Glättungsabschnitt (25), der so konfiguriert ist, dass er ein Ausgangssignal des Verstärkungsabschnitts glättet,
einen Phasenwinkeleinstellungsabschnitt (23), der so konfiguriert ist, dass er einen Startpunkt für die Rauschmessung für jede Verbindung zwischen der ersten Phase und der zweiten Phase, zwischen der zweiten Phase und der dritten Phase und zwischen der dritten Phase und der ersten Phase einstellt,
einen Phasenteilungsabschnitt (24), der so konfiguriert ist, dass er eine Vielzahl von Domänen definiert, indem er einen Zyklus einer Spannungswellenform oder einer Stromwellenform jeder Verbindung zwischen der ersten Phase und der zweiten Phase, zwischen der zweiten Phase und der dritten Phase und zwischen der dritten Phase und der ersten Phase auf der Grundlage des Startpunkts der Rauschmessung unterteilt, und
einen Bestimmungsabschnitt (26), der so konfiguriert ist, dass er ein Rauschen bei einer vorbestimmten Frequenz erfasst, die in einem Ausgangssignal des Glättungsabschnitts enthalten ist, der so konfiguriert ist, dass er mindestens eine Domäne angibt, die mit einem Zeitpunkt der Erfassung des Rauschens aus der Vielzahl von Domänen, die durch den Phasenteilungsabschnitt definiert sind, übereinstimmt, und der so konfiguriert ist, dass er angibt, welche Verbindung zwischen der ersten Phase und der zweiten Phase, zwischen der zweiten Phase und der dritten Phase oder zwischen der dritten Phase und der ersten Phase die Quelle des Rauschens ist.

2. Entladungsdetektor gemäß Anspruch 1, wobei der Phasenwinkeleinstellungsabschnitt einen ersten Startpunkt der Rauschmessung basierend auf der Spannungswellenform oder der Stromwellenform einer beliebigen Phasenverbindung zwischen der ersten Phase und der zweiten Phase, zwischen der zweiten Phase und der dritten Phase oder zwischen der dritten Phase und der ersten Phase bestimmt und den zweiten und dritten Startpunkt der Rauschmessung für die beiden anderen Phasenverbindungen auf der Grundlage des ersten Startpunkts der Rauschmessung und einer Verschiebung des Phasenwinkels der Spannungswellenform oder der Stromwellenform jeder Verbindung zwischen der ersten Phase und der zweiten Phase, zwischen der zweiten Phase und der dritten Phase und zwischen der dritten Phase und der ersten Phase bestimmt.

3. Entladungsdetektor nach Anspruch 1, wobei der Phasenwinkeleinstellungsabschnitt den Startpunkt der Rauschmessung für jede Verbindung zwischen der ersten Phase und der zweiten Phase, zwischen der zweiten Phase und der dritten Phase und zwischen der dritten Phase und der ersten Phase auf der Grundlage der Spannungswellenform oder der Stromwellenform jeder dieser drei Phasenverbindungen bestimmt.

4. Entladungsdetektor nach Anspruch 1, wobei der Phasenteilungsabschnitt eine Spitzenzeitdomäne, die die Zeit vor und nach einem Spitzenwert umfasst, und eine Nulldurchgangszeitdomäne, die die Zeit vor und nach einem Wert von 0 umfasst, für einen Zyklus der Spannungswellenform oder der Stromwellenform jeder Verbindung zwischen der ersten Phase und der zweiten Phase, zwischen der zweiten Phase und der dritten Phase und zwischen der dritten Phase und der ersten Phase definiert, und
der Bestimmungsabschnitt einen Differenzwert zwischen einem ersten Ausgangssignal des Glättungsabschnitts in der Spitzenzeitdomäne und eines zweiten Ausgangssignal des Glättungsabschnitts in der Nulldurchgangszeitdomäne berechnet und, wenn der Differenzwert einen ersten Schwellenwert oder mehr beträgt, bestimmt, dass eine Entladung aufgetreten ist, und angibt, welche Verbindung zwischen der ersten Phase und der zweiten Phase, zwischen der zweiten Phase und der dritten Phase oder zwischen der dritten Phase und der ersten Phase die Quelle der Entladung ist.

5. Entladungsdetektor nach Anspruch 1, wobei der Phasenteilungsabschnitt eine Spitzenzeitdomäne definiert, der die Zeit vor und nach einem Spitzenwert für einen Zyklus der Spannungswellenform oder der Stromwellenform jeder Verbindung zwischen der ersten Phase und der zweiten Phase, zwischen der zweiten Phase und der dritten Phase und zwischen der dritten Phase und der ersten Phase umfasst, und
der Bestimmungsabschnitt angibt, wenn der Zeitpunkt der Erkennung des Rauschens mit der Spitzenzeitdomäne übereinstimmt, welche Verbindung zwischen der ersten Phase und der zweiten Phase, zwischen der zweiten Phase und der dritten Phase oder zwischen der dritten Phase und der ersten Phase die Quelle des Rauschens ist.

6. Entladungsdetektor nach Anspruch 4, wobei der Bestimmungsabschnitt bestimmt, ob das zweite Ausgangssignal des Glättungsabschnitts in der Nulldurchgangszeitdomäne einen zweiten Schwellenwert oder mehr beträgt, wobei der zweite Schwellenwert ein Wert ist, der kleiner als der erste Schwellenwert ist, und wenn das zweite Ausgangssignal den zweiten Schwellenwert oder mehr beträgt, meldet, dass es nicht möglich ist, zu bestimmen, ob eine Entladung aufgetreten ist.

7. Entladungsdetektor gemäß Anspruch 4, wobei der Bestimmungsabschnitt bestimmt, ob das zweite Ausgangssignal des Glättungsabschnitts in der Nulldurchgangszeitdomäne einen zweiten Schwellenwert oder mehr beträgt, wobei der zweite Schwellenwert ein Wert ist, der kleiner als der erste Schwellenwert ist, und wenn das zweite Ausgangssignal den zweiten Schwellenwert oder mehr beträgt, einen Verstärkungsfaktor des Verstärkungsabschnitts reduziert.

## Revendications

1. Détecteur de décharge destiné à détecter qu'une décharge se produit sur la base d'un bruit dans une bande hautes fréquences superposée sur une source de puissance en courant alternatif provenant d'un circuit de puissance d'un courant alternatif triphasé, le détecteur de décharge comprenant :
au moins une section de filtre (21) connectée électriquement entre deux phases parmi une première phase, une deuxième phase, et une troisième phase du circuit de puissance, et configurée pour extraire une composante de fréquence prédéterminée à partir de la source de puissance en courant alternatif,
une section d'amplification (22) configurée pour amplifier une sortie de la section de filtre,
une section de lissage (25) configurée pour lisser une sortie de la section d'amplification,
une section d'établissement d'angle de phase (23) configurée pour établir un point de départ d'un mesurage de bruit pour chaque connexion entre la première phase - la deuxième phase, entre la deuxième phase - la troisième phase, et entre la troisième phase - la première phase,
une section de division de phase (24) configurée pour définir une pluralité de domaines en divisant un cycle d'une forme d'onde de tension ou une forme d'onde de courant de chaque connexion entre la première phase - la deuxième phase, entre la deuxième phase - la troisième phase, et entre la troisième phase - la première phase sur la base du point de départ d'un mesurage de bruit, et
une section de détermination (26) configurée pour détecter un bruit à une fréquence prédéterminée incluse dans une sortie de la section de lissage, configurée pour spécifier au moins un domaine coïncidant avec une temporisation de détection du bruit parmi la pluralité de domaines définis par la section de division de phase, et configurée pour spécifier laquelle des connexions entre la première phase - la deuxième phase, entre la deuxième phase - la troisième phase, ou entre la troisième phase - la première phase est une source du bruit.

2. Détecteur de décharge selon la revendication 1, dans lequel la section d'établissement d'angle de phase détermine un point de départ d'un mesurage de bruit sur la base de la forme d'onde de tension ou de la forme d'onde de courant d'une phase de connexion quelconque entre la première phase - la deuxième phase, entre la deuxième phase - la troisième phase, ou entre la troisième phase - la première phase, et détermine un deuxième et un troisième point de départ d'un mesurage de bruit pour les deux autres connexions de phase sur la base du premier point de départ d'un mesurage du bruit et d'un décalage dans un angle de phase de la forme d'onde de tension ou de la forme d'onde de courant de chaque connexion entre la première phase - la deuxième phase, entre la deuxième phase - la troisième phase, et entre la troisième phase - la première phase.

3. Détecteur de décharge selon la revendication 1, dans lequel la section d'établissement d'angle de phase détermine le point de départ d'un mesurage de bruit pour chaque connexion entre la première phase - la deuxième phase, entre la deuxième phase - la troisième phase, et entre la troisième phase - la première phase sur la base de la forme d'onde de tension ou de la forme d'onde de courant de chacune de ces trois connexions de phase.

4. Détecteur de décharge selon la revendication 1, dans lequel la section de division de phase définit un domaine temporel de crête incluant un temps avant et après une valeur crête et un domaine temporel de passage par zéro incluant un temps avant et après une valeur 0 pour ledit un cycle de la forme d'onde de tension ou de la forme d'onde de courant de chaque connexion entre la première phase - la deuxième phase, entre la deuxième phase - la troisième phase, et entre la troisième phase - la première phase, et
la section de détermination calcule une valeur d'une différence entre une première sortie de la section de lissage dans le domaine temporel de crête et une seconde sortie de la section de lissage dans le domaine temporel de passage par zéro, et si la valeur de différence est un premier seuil ou une valeur supérieure, détermine qu'une décharge s'est produite et spécifie laquelle des connexions entre la première phase - la deuxième phase, entre la deuxième phase - la troisième phase, ou entre la troisième phase - la première phase est une source de la décharge.

5. Détecteur de décharge selon la revendication 1, dans lequel la section de division de phase définit un domaine temporel de crête incluant un temps avant et après une valeur crête pour ledit un cycle de la forme d'onde de tension ou de la forme d'onde de courant de chaque connexion entre la première phase - la deuxième phase, entre la deuxième phase - la troisième phase, et entre la troisième phase - la première phase, et
la section de détermination spécifie, si la temporisation de détection du bruit coïncide avec le domaine temporel de crête, laquelle des connexions entre la première phase - la deuxième phase, entre la deuxième phase - la troisième phase, ou entre la troisième phase - la première phase est la source du bruit.

6. Détecteur de décharge selon la revendication 4, dans lequel la section de détermination détermine si la deuxième sortie de la section de lissage dans le domaine temporel de passage par zéro est un deuxième seuil ou une valeur supérieure, le deuxième seuil étant une valeur inférieure au premier seuil, et si la deuxième sortie est le deuxième seuil ou une valeur supérieure, rapporte qu'il n'est pas possible de déterminer si une décharge s'est produite.

7. Détecteur de décharge selon la revendication 4, dans lequel la section de détermination détermine si la deuxième sortie de la section de lissage dans le domaine temporel de passage par zéro est un deuxième seuil ou une valeur supérieure, le deuxième seuil étant une valeur inférieure au premier seuil, et si la deuxième sortie est le deuxième seuil ou une valeur supérieure, réduit un facteur d'amplification de la section d'amplification.
